# EUROPEAN PATENT APPLICATION

(11) **EP 4 568 041 A1**
(43) Date of publication of application: **11.06.2025**
(21) Application number: 24217424.1
(22) Date of filing: 04.12.2024
(51) Int. Cl.: H02J 1/02, H02J 7/00, H05K 7/14

(54) **VEHICLE ELECTRIC SYSTEM INCLUDING AN EMC FILTERING DEVICE**

(30) Priority: 06.12.2023 IT 202300026124
(71) Applicant: FERRARI S.p.A., 41100 Modena (IT)
(72) Inventor: CASOLI, Luca, 41100 Modena (IT); SITTA, Ugo, 41100 Modena (IT); RENDINE, Andrea, 41100 Modena (IT); LO CALZO, Giovanni, 41100 Modena (IT); ROVELLI, Enrico, 41100 Modena (IT)
(74) Representative: Studio Torta S.p.A.

(57) **Abstract**

A vehicle electric system has an electrical connection device (5) to connect a power supply device (4) and at least one electric/electronic apparatus (2, 3) to one another, a filtering device (6) associated with the electrical connection device (5) to at least limit interfering voltages and/or currents generated by the electric/electronic apparatus (2, 3), and at least one elastic connection element (16) made of a conductive material and interposed between the electrical connection device (5) and the filtering device (6) to power the filtering device (6) with the electric current supplied through the electrical connection device (5).

## Description

### CROSS-REFERENCE TO RELATED APPLICATIONS

This patent application claims priority from Italian patent application no. 102023000026124 filed on December 6, 2023, the entire disclosure of which is incorporated herein by reference.

### TECHNICAL FIELD

The invention relates to a vehicle electric system.

In particular, the invention relates to a vehicle electric system of the type comprising at least one electric/electronic apparatus; a power supply device, normally a battery, to electrically power the electric/electronic apparatus; an electrical connection device to connect the power supply device and the electric/electronic apparatus to one another; and a filtering device associated with the electrical connection device to at least limit interfering voltages and/or currents generated by the electric/electronic apparatus itself.

### BACKGROUND

Generally speaking, the electrical connection device comprises a busbar provided with a plurality of conductor bars made of a metal material, for example copper or aluminium; and the filtering device comprises a passive EMC (Electromagnetic Compatibility) filter provided with a printed circuit board and with a plurality of electronic components, in particular capacitors and inductances, mounted on the printed circuit board and electrically connected to one another through the printed circuit board.

Known vehicle electric systems of the type described above suffer from some drawbacks, which are mainly due to the fact that the electrical connection between the conductor bars of the electrical connection device and the printed circuit board of the filtering device is made by connecting the conductor bars to the printed circuit board by means of welding or fixing screws, involves relatively long, complex and expensive production processes and can be compromised by the thermal expansion phenomena, to which the conductor bars are subjected.

### SUMMARY

The object of the invention is to provide a vehicle electric system that is not affected by the aforementioned drawbacks and can be manufactured in a simple and economic fashion.

According to the invention, there is provided a vehicle electric system as claimed in the appended claims.

### BRIEF DESCRIPTION OF THE DRAWINGS

The invention will now be described with reference to the accompanying drawings showing a non-limiting embodiment thereof, wherein:
figure 1 schematically shows a preferred embodiment of the vehicle electric system according to the invention;

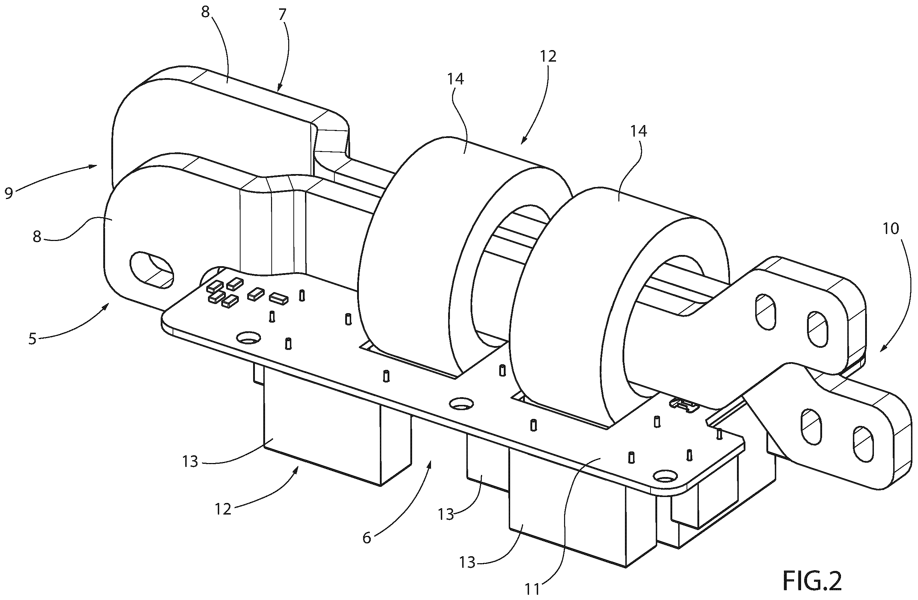

figure 2 is a schematic perspective view of a detail of the vehicle electric system of figure 1;

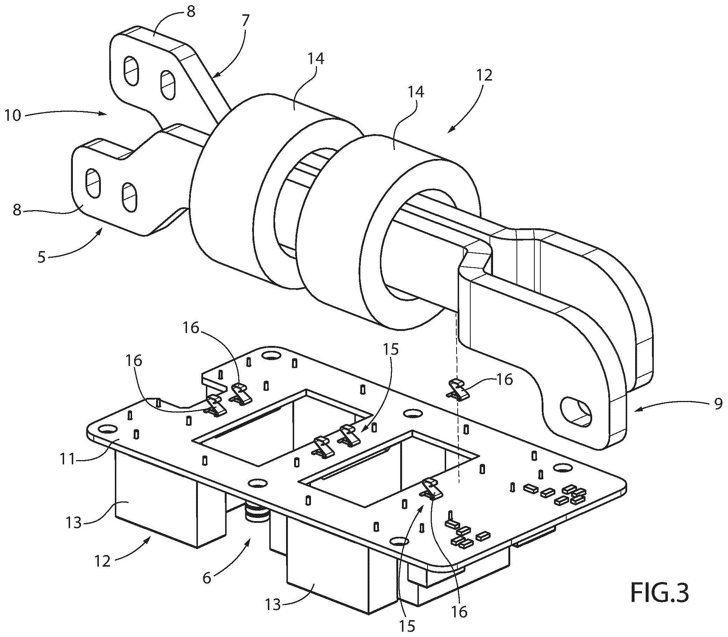

figure 3 is a schematic exploded perspective view of the detail of figure 2;

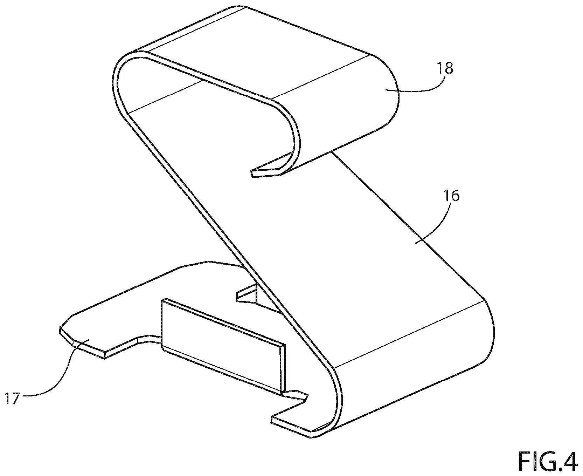

figure 4 is a perspective view of a detail of figures 2 and 3; and
figures 5 and 6 are two schematic perspective views of a variant of the detail of figure 2.

### DESCRIPTION OF EMBODIMENTS

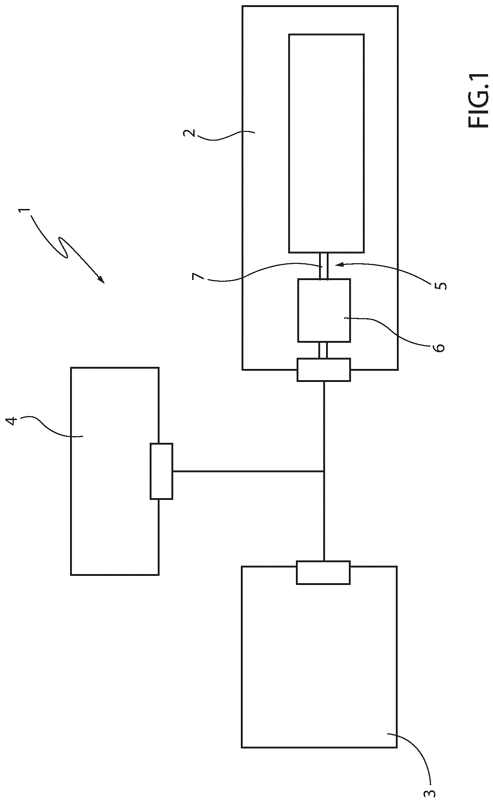

With reference to figure 1, number 1 indicates, as a whole, a vehicle electric system mounted in a road vehicle (not shown).

The electric system comprises a first electric/electronic apparatus 2; a second electric/electronic apparatus 3; and a power supply device 4, normally a battery, to electrically power the apparatuses 2 and 3.

The electric system 1 further comprises an electrical connection device 5 to connect the power supply device 4 and the apparatus 2 to one another; and a filtering device 6 associated with the device 5 to at least limit interfering voltages and/or currents generated by the apparatus 2.

The device 5 comprises a busbar 7 having a plurality of bars 8 made of a conductive material (in this case, two bars 8), each having an input 9 connected to the device 4 and an output 10 connected to the apparatus 2. In particular, the bars 8 extend along respective longitudinal axes, preferably parallel to one another.

The device 6 comprises a passive EMC (Electromagnetic Compatibility) filter provided with a printed circuit board 11 with a flat shape and a plurality of electronic components 12 mounted on the printed circuit board 11 and electrically connected to one another through the printed circuit board 11.

The electronic components 12 comprise, in this specific case, a plurality of capacitors 13 mounted on the printed circuit board 11 and a pair of inductances 14 with a tubular shape, which are mounted through the printed circuit board 11 and extend around the bars 8, in particular around the respective longitudinal axes.

The electric system 1 is further provided with a plurality of electrical connection members 15 to power the filtering device 6 with the electric current supplied through the bars 8 of the electrical connection device 5.

Each member 15 comprises an elastic connection element defined by a shaped leaf spring 16, which is made of a conductive material, is interposed between the electrical connection device 5 and the filtering device 6 and has a first end 17 fixed, in this case welded, to the printed circuit board 11 and a second end 18 electrically connected to a relative bar 8 through mechanical interference.

More in detail:
each bar 8 is electrically connected to the printed circuit board 11 through the interposition of three springs 16; and
each bar 8 substantially extends in a vertical containing plane perpendicular to the printed circuit board 11 and extends parallel to the printed circuit board 11, namely it does not intersect the printed circuit board 11.

In use, the electrical connection between the bars 8 of the electrical connection device 5 and the printed circuit board 11 of the filtering device 6 allows the filtering device 6 to at least limit interfering voltages and/or currents by the apparatus 2 so as to guarantee a relatively correct operation of the apparatus 3.

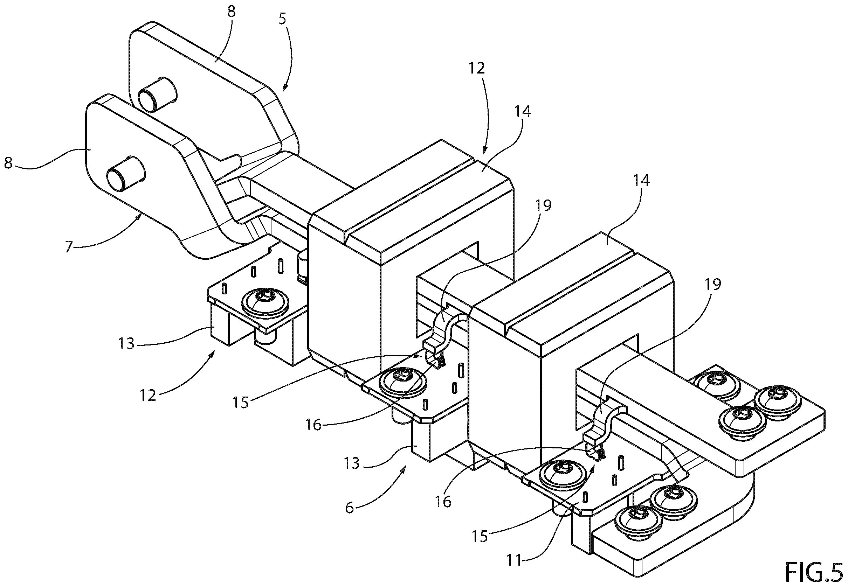

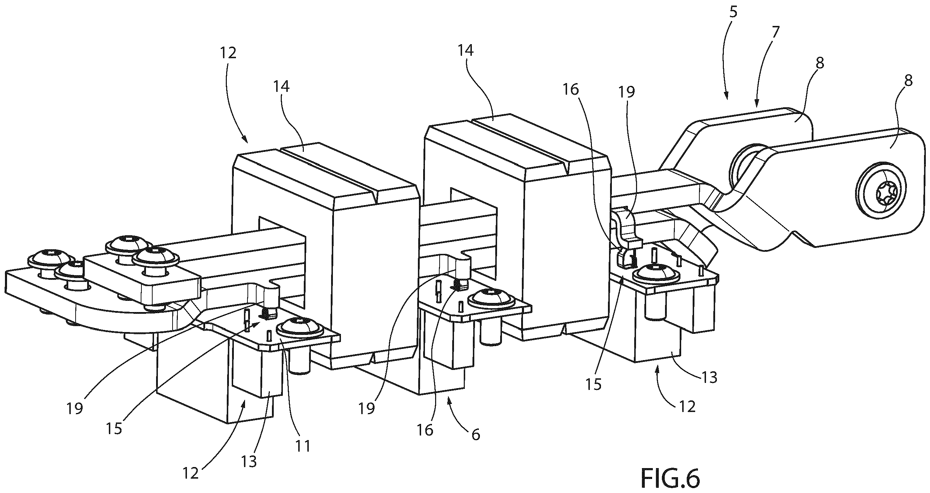

The variant shown in figures 5 and 6 differs from the one shown in the preceding figures only in that, in it:
each bar 8 substantially extends in a containing plane parallel to the printed circuit board 11 and extends parallel to the printed circuit board 11, namely it does not intersect the printed circuit board 11; and
each bar 8 is provided with a plurality of appendages 19, which are distributed along the bar 8 and laterally project from the bar 8 to be coupled, through mechanical interference, to relative springs 6 and electrically connect the bar 8 and the printed circuit board 11 to one another.

Therefore, advantageously, though not in a limiting manner, in these embodiments, the springs 6 are not exactly interposed between the bar 8 and the printed circuit board 11, but they are arranged between the printed circuit board 11 and the side appendages 19. In this way, the installation and verification of the correct contact are simpler as they are more easily visible and testable.

In particular, each appendage 19 at least partially extends along a direction that is transverse to the respective longitudinal axis of the bar 8.

In detail, the longitudinal axes of the bars 8 are parallel to the printed circuit board 11.

Preferably and as shown in the non-limiting embodiment of figures 5 and 6, each bar 8 comprises a plurality of appendages 19 (three in the examples shown herein), each coupled to a respective spring 6 to electrically connect the bar 8 and the printed circuit board 11 to one another.

In particular, at least one pair of appendages 19 is located on a same side of the bar 8. More in particular, some appendages 19 (two) are located on a same side of the bar 8, while other appendages 19 (one) are located on the opposite side. The fact of having appendages 19 on two opposite sides of the bar 8 avoids a twisting moment of the bar 8 due to the springs 6. Indeed, the bar 8 preferably is in contact with at least three springs 6 not lying on a same straight line, thus defining a coupling plane defined by the three contact points, at least one of which lies on a different line from the other two.

In the non-limiting embodiment of figure 5 and figure 6, the appendages 19 of the bar 8 most distant from the printed circuit board are S-shaped, having a (central) portion that protrudes towards the printed circuit board 11. In this way, there is a compensation of the greater distance of the upper bar 8 from the printed circuit board 11, whose springs 6 are reached by the appendages 19 of the upper bar 8, which project past the thickness of the lower bar 8 until they reach the springs 6 of the printed circuit board 11.

Advantageously, though not in a limiting manner, the distal portion of the appendages 19, namely the portion not attached to the bar, is at least partially parallel to the printed circuit board 11. In particular, said distal portion is parallel both to the printed circuit board 11 and to the respective proximal portion (namely, attached to the bar 8) of the appendage 19.

Preferably, though not in a limiting manner, the appendages 19 are manufactured as one single piece together with the respective bar 8.

## Claims

1. A vehicle electric system comprising at least one electric/electronic apparatus (2, 3); a power supply device (4) to electrically power the electric/electronic apparatus (2, 3); an electrical connection device (5) to connect the power supply device (4) and the electric/electronic apparatus (2, 3) to one another; a filtering device (6) associated with the electrical connection device (5) to at least limit interfering voltages and/or currents generated by said electric/electronic apparatus (2, 3); and electrical connection means (15) to power the filtering device (6) with the electric current supplied through the electrical connection device (5); and **characterized in that** the electrical connection means (15) comprise at least one elastic connection element (16) made of a conductive material and interposed between the electrical connection device (5) and the filtering device (6).

2. The system according to claim 1, wherein each elastic connection element (16) comprises a spring fixed to the filtering device (6) and stressed in a compressive manner by the electrical connection device (5).

3. The system according to claim 1 or 2, wherein the electrical connection device (5) comprises a busbar (7).

4. The system according to any one of the preceding claims, wherein the filtering device (6) comprises a passive EMC (Electromagnetic Compatibility) filter.

5. The system according to claim 4, wherein the filtering device (6) comprises a printed circuit board (11) and a plurality of electronic components (12), in particular capacitors (13) and inductances (14), mounted on the printed circuit board (11) and electrically connected to one another through the printed circuit board (11).

6. The system according to claim 5, wherein the electrical connection device (5) comprises at least one conductor bar (8) mounted between the power supply device (4) and said electric/electronic apparatus (2, 3); each elastic connection element (16) being interposed between the printed circuit board (11) of the filtering device (6) and a relative conductor bar (8).

7. The system according to claim 6, wherein each electric connection element (16) comprises a shaped leaf spring having a first end (17) fixed to the printed circuit board (11) and a second end (18) electrically connected to the relative conductor bar (8) through mechanical interference.

8. The system according to claim 6 or 7, wherein the filtering device (6) comprises at least one inductance (14) with an annular shape mounted on the printed circuit board (11), and wherein each conductor bar (8) extends through the inductances (14).

9. The system according to any one of the claims from 6 to 8, wherein the conductor bars (8) extend parallel to the printed circuit board (11).

10. The system according to any one of the claims from 6 to 9, wherein each conductor bar (8) is provided with at least one appendage (19) projecting from the conductor bar (8) so as to interfere with a relative elastic connection element (16).
